# EUROPEAN PATENT APPLICATION

(11) **EP 2 048 717 A1**
(43) Date of publication of application: **15.04.2009**
(21) Application number: 07118189.5
(22) Date of filing: 10.10.2007
(51) Int. Cl.: H01L 33/00

(54) **Structure of light-emitting diode**

(71) Applicant: Unity Opto Technology Co., Ltd., San Chung City, Taipei Hsien, Taiwan (TW)
(72) Inventor: Wu, Ching-Huei, San Chung City (TW); Wu, Chih-Hsien, San Chung City (TW)
(74) Representative: Viering, Jentschura & Partner

(57) **Abstract**

A structure of 1ightemitting diode includes a carrier rack (10), at least one light-emitting chip (20), and a fluorescent layer (30). The carrier rack forms a recessed cavity (11). The at least one light-emitting chip (20) is mounted in the cavity (11) of the carrier rack (10). The fluorescent layer (30) is mounted to an edge of a circumferential wall of the carrier rack (10) and, below the fluorescent layer (30), a receiving space (40) is formed between the fluorescent layer (30) and the carrier rack (10). The receiving space (40) is set in a vacuum condition or is alternatively filled with an inert gas to prevent reduction of excitement efficiency of the fluorescent powder or color deterioration and also to prevent the light-emitting chip from oxidization caused by air and the reduction of overall light emission efficiency caused by temperature rise due to the oxidization, whereby the light emission efficiency and lifespan of the light-emitting diode are enhanced.

## Description

### BACKGROUND OF THE INVENTION

### 1. Field of the Invention

The present invention relates to a structure of light-emitting diode, which is formed of a combination of a carrier rack, at least one light-emitting chip, and a fluorescent layer, wherein the fluorescent layer and the carrier rack form therebetween a receiving space which is set in a vacuum condition or is filled with an inert gas to prevent reduction of excitement efficiency of fluorescent powder and color deterioration and to prevent the at least one light-emitting chip from being oxidized by air and reduction of overall light emission efficiency caused by temperature rise caused by the oxidization to thereby enhance light emission efficiency and lifespan of the light-emitting diode, and which is applicable to light-emitting diode or similar structures.

### 2. The Related Arts

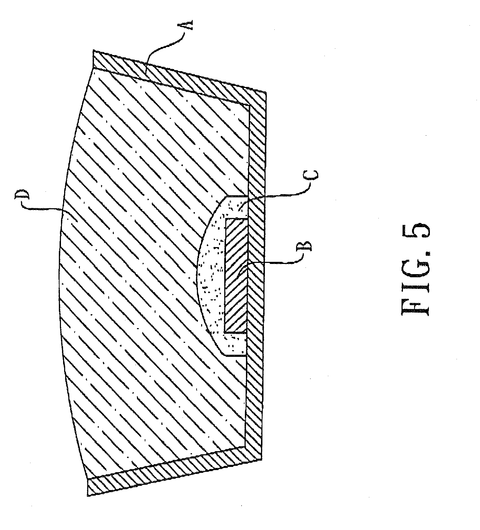

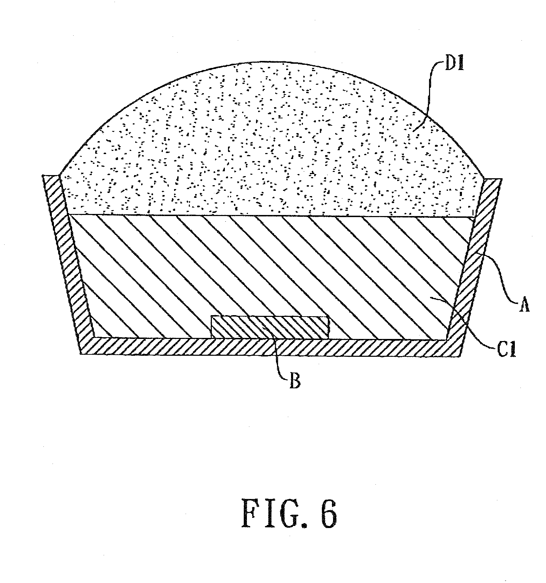

Figure 5 of the attached drawings shows a conventional structure of light-emitting diode, which comprises a carrier rack A forming a recessed cavity, a chip B, and a light-transmitting layer D. The chip B is mounted to the cavity of the carrier rack A. An outer side of the chip B is covered by a layer C of fluorescent powder. The light-transmitting layer D is made of clear plastics, which is filled into the cavity of the carrier rack A to thereby enclose the fluorescent powder layer C. Since the fluorescent powder layer C is set in direct contact with the chip B, the light emitted from the chip B is not absorbed by any intervening medium so that enhanced light emission efficiency can be obtained. However, the chip B, which emits light, also gives off heat, which may cause over-heating of the fluorescent powder layer C, leading to color deterioration of the light-emitting diode and reduction of the lifespan of the light-emitting diode. Another known structure of light-emitting diode is shown in Figure 6, which differs from the known structure described above in that a light-transmitting plastic layer C1 is formed atop the chip B that is mounted in the carrier rack A and a light-transmitting layer D1 is further formed on the light-transmitting plastic layer C1. The light-transmitting layer D1 is formed of a mixture of fluorescent powder and light-transmitting plastics or can alternatively be an optic lens to prevent the problem of color deterioration caused by over-heating due to direct contact of the chip B with the fluorescent powder. However, since the light emitted from the chip B must transmit through the light-transmitting plastic layer C1, a fraction of the light is absorbed by the clear plastics that make the light-transmitting plastic layer C1, thereby reducing the excitement efficiency of the fluorescent powder.

Thus, the present invention is aimed to provide a structure of light-emitting diode that overcomes the drawbacks of the conventional structures of light-emitting diode.

### SUMMARY OF THE INVENTION

An objective of the present invention is to provide a structure of light-emitting diode, which is formed of a combination of a carrier rack, at least one light-emitting chip, and a fluorescent layer, wherein the fluorescent layer is arranged above the at least one light-emitting chip and covers light emission zone of the at least one light-emitting chip to thereby form a receiving space between the fluorescent layer and the carrier rack, which receiving space is set in a vacuum condition or is alternatively filled with an inert gas to prevent color deterioration caused by direct contact of the heat generated by emission of light by the at least one light-emitting chip with the fluorescent layer so that lifespan of the light-emitting diode is extended and uniform mixing of light is obtained to realize improvement of overall practicability.

Another objective of the present invention is to provide a structure of light-emitting diode, which is formed of a combination of a carrier rack, at least one light-emitting chip, and a fluorescent layer, wherein the fluorescent layer and the carrier rack form a receiving space therebetween, which receiving space is set in a vacuum condition or is alternatively filled with an inert gas to suppress heat transfer and thus protect the at least one light-emitting chip from oxidization often caused by the interaction between the light emitted from the at least one light-emitting chip and oxygen contained in air and prevent the reduction of light emission efficiency caused by rise of temperature due to the oxidization and prevent reduction of light emission efficiency caused by lowered excitement efficiency of the fluorescent powdered that is caused by the absorption of a fraction of the light emitted from the at least one light-emitting chip by the light-transmitting plastics (or light-transmitting plastics mixed with fluorescent powders) due to the direct transmission of the light from the at least one light-emitting chip into the light-transmitting plastics to thereby enhance the light emission efficiency and the lifespan of the light-emitting diode and thus improving practicability thereof.

To realize the above objective, in accordance with the present invention, there is provided a structure of light-emitting diode comprising a carrier rack, at least one light-emitting chip, and a fluorescent layer. The carrier rack forms a recessed cavity. The at least one light-emitting chip is mounted in the cavity of the carrier rack. The fluorescent layer is mounted to an edge of a circumferential wall of the carrier rack and, below the fluorescent layer, a receiving space is formed between the fluorescent layer and the carrier rack. The receiving space is set in a vacuum condition or is alternatively filled with an inert gas to thereby enhance the overall practicability.

The present invention will become more obvious from the following description when taken in connection with the accompanying drawings, which show, for purposes of illustration only, preferred embodiments in accordance with the present invention. In the drawings:

### BRIEF DESCRIPTION OF THE DRAWINGS

Figure 1 is a cross-sectional view showing a light-emitting diode constructed in accordance with a first embodiment of the present invention;

Figure 2 is also a cross-sectional view of the light-emitting diode of the first embodiment of the present invention in an exploded form;

Figure 3 is a cross-sectional view showing a light-emitting diode constructed in accordance with a second embodiment of the present invention;

Figure 4 is also a cross-sectional view of the light-emitting diode of the second embodiment of the present invention in an exploded form;

Figure 5 is a cross-sectional view illustrating a conventional structure of light-emitting diode; and

Figure 6 is a cross-sectional view illustrating another conventional structure of light-emitting diode.

### DETAILED DESCRIPTION OF THE PREFERRED EMBODIMENTS

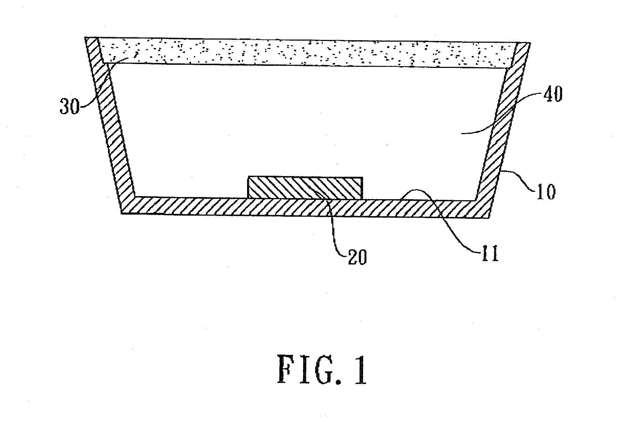

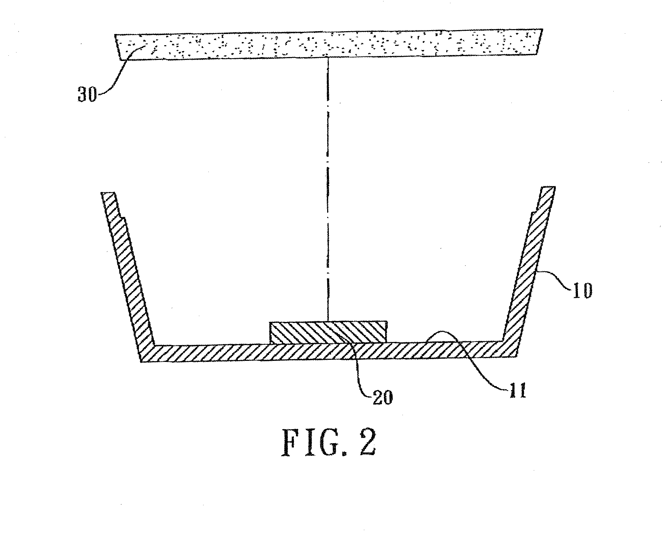

With reference to the drawings and in particular to Figures 1 and 2, a light-emitting diode constructed in accordance with a first embodiment of the present invention comprises a carrier rack 10, which forms a recessed cavity 11. The cavity 11 is of a cup-like configuration to enhance collection of light. At least one light-emitting chip 20 is mounted in the cavity 11 of the carrier rack 10 by means of for example flip chip or wire bonding. A fluorescent layer 30 is mounted to an edge of a circumferential wall of the carrier rack 10 in such a way that a bottom of the fluorescent layer 30 and the carrier rack 10 form therebetween a receiving space 40, which is set in a vacuum condition.

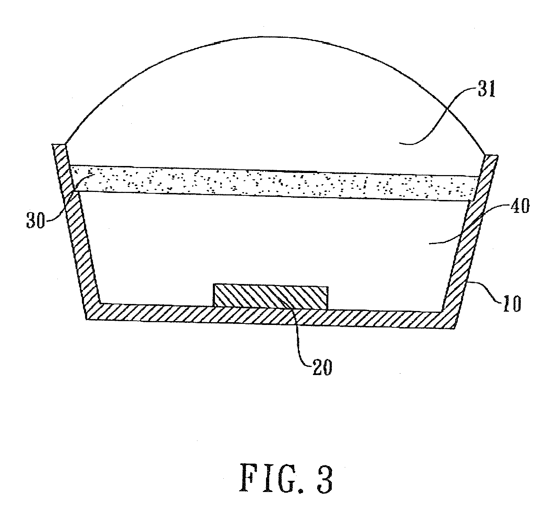

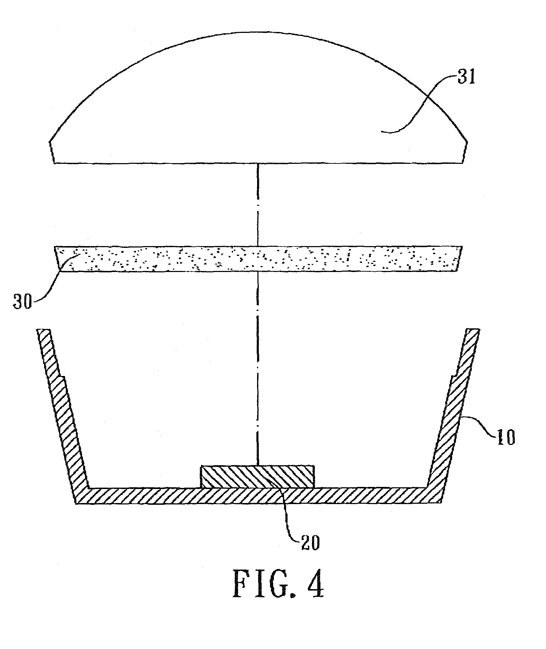

Further, as demonstrated by a second embodiment of the present invention that is shown in Figures 3 and 4, a light-transmitting layer 31 is formed atop the fluorescent layer 30. The light-transmitting layer 31 can be for example an optic lens, a glass member or a body of light-transmitting plastics for converging light. The light-transmitting plastics that make the light-transmitting layer 31 can be for example epoxy (EP) resin, polyphthalamide (PPA) or silicone.

Although the receiving space 40 is set in a vacuum in the first and second embodiments described above, the receiving space 40 can be alternatively filled with an inert gas, including nitrogen, helium, neon, argon, krypton, xenon, radon, and the likes. To assemble, the at least one light-emitting chip 20 is first mounted to the carrier rack 10. The fluorescent powder and the light-transmitting plastics are mixed to form the fluorescent layer 30, or alternatively, the fluorescent powder is uniformly coated or sprayed onto a bottom face of the light-transmitting layer 31 to form the fluorescent layer 30. Then, the fluorescent layer 30 and the carrier rack 10 to which the at least one light-emitting chip 20 is mounted are both deposited in a vacuum environment or in an atmosphere of nitrogen or other inert gas, followed by fixing the fluorescent layer 30 to the edge of the wall of the carrier rack 10 with a predetermine distance set from below the fluorescent layer 30 to the carrier rack 10 to form the receiving space 40, which is thus in a vacuum condition or filled with nitrogen or other inert gas. As such, assembling of the light-emitting diode in accordance with the present invention is completed.

Referring to Figures 1-4, with such a structure described above, the light-emitting diode in accordance with the present invention features that the light-emitting diode is formed of a combination of a carrier rack 10, at least one light-emitting chip 20, a fluorescent layer 30, wherein the fluorescent layer 30 is mounted to the carrier rack 10 to form a receiving space 40, which sets a predetermined distance between the at least one light-emitting chip 20 and the fluorescent layer 30 to prevent the fluorescent layer 30 from directly contacting the at least one light-emitting chip 20 and being heated by the heat generated by the light emission of the at least one light-emitting chip 20 and thereby preventing color deterioration of the light-emitting diode caused by over-heating. Further, since the receiving space 40 is set in a vacuum condition or is filled with an inert gas, light emitted from the at least one light-emitting chip 20 is prevented from interaction with oxygen contained in air to thereby prevent oxidization of the at least one light-emitting chip 20 and to prevent reduction of light emission efficiency caused by rise of temperature due to the oxidization and to further prevent the reduction of excitement efficiency of the fluorescent powder, which influences the light emission efficiency and which is due to the light emitted from the at least one light-emitting chip 20 directly transmits into the light-transmitting plastics or the light-transmitting plastics mixed with fluorescent powder and a fraction of light emitted from the at least one light-emitting chip 20 being absorbed by the light-transmitting plastics. Further, since the receiving space 40 between the fluorescent layer 30 and the carrier rack 10 is set in a vacuum condition or is filled with an inert gas, heat transfer is suppressed, which enhances the light emission efficiency and lifespan of the light-emitting diode. And since the fluorescent layer 30 is mounted above the at least one light-emitting chip 20 and covers above a light emission zone of the at least one light-emitting chip 20, the light emitted from the at least one light-emitting chip 20 is guided through the fluorescent layer 30 to effect mixing of light so that the present invention features uniform light mixing, excellent light emission efficiency, and extended lifespan and thus the practicability and convenience are improved.

Although the present invention has been described with reference to the preferred embodiments thereof, it is apparent to those skilled in the art that a variety of modifications and changes may be made without departing from the scope of the present invention which is intended to be defined by the appended claims.

## Claims

1. A light-emitting diode, comprising:
a carrier rack forming a recessed cavity;
at least one light-emitting chip mounted in the cavity; and
a fluorescent layer mounted to an edge of a wall of the carrier rack and forming a receiving space between a bottom of the fluorescent layer and the carrier rack, the receiving space being set in a vacuum condition.

2. The light-emitting diode as claimed in Claim **1** further comprising a light-transmitting layer formed atop the fluorescent layer.

3. The light-emitting diode as claimed in Claim **2,** wherein the light-transmitting layer comprises an optic lens.

4. The light-emitting diode as claimed in Claim **2,** wherein the light-transmitting layer comprises a body of light-transmitting plastics and wherein the light-transmitting plastics are selected from a group consisting of epoxy resin, polyphthalamide, and silicone.

5. The light-emitting diode as claimed in Claim **2,** wherein the light-transmitting layer comprises a glass member.

6. A light-emitting diode, comprising:
a carrier rack forming a recessed cavity;
at least one light-emitting chip mounted in the cavity; and
a fluorescent layer mounted to an edge of a wall of the carrier rack and forming a receiving space between a bottom of the fluorescent layer and the carrier rack, the receiving space being filled with an inert gas.

7. The light-emitting diode as claimed in Claim **6** further comprising a light-transmitting layer formed atop the fluorescent layer.

8. The light-emitting diode as claimed in Claim **7,** wherein the light-transmitting layer comprises an optic lens.

9. The light-emitting diode as claimed in Claim **7,** wherein the light-transmitting layer comprises a body of light-transmitting plastics and wherein the light-transmitting plastics are selected from a group consisting of epoxy resin, polyphthalamide, and silicone.

10. The light-emitting diode as claimed in Claim **7,** wherein the light-transmitting layer comprises a glass member.

11. The electrical device as claimed in Claim **6,** wherein the insert gas is selected from a group consisting nitrogen, helium, neon, argon, krypton, xenon, and radon.
